(19) Europäisches Patentamt
European Patent Office
Office européen des brevets

(11) **EP 2 719 519 A1**

(12) **EUROPEAN PATENT APPLICATION**
published in accordance with Art. 153(4) EPC

(43) Date of publication:
**16.04.2014 Bulletin 2014/16**

(21) Application number: **11867467.0**

(22) Date of filing: **09.06.2011**

(51) Int Cl.:
**B29C 70/06** (2006.01)

(86) International application number:
**PCT/JP2011/003258**

(87) International publication number:
**WO 2012/168975 (13.12.2012 Gazette 2012/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(71) Applicant: **Shin Nippon Koki Co., Ltd.
Osaka-shi
Osaka 541-0057 (JP)**

(72) Inventor: **NISHIBASHI, Nobutaka
Osaka 541-0057 (JP)**

(74) Representative: **Müller-Boré & Partner
Patentanwälte PartG mbB
Friedenheimer Brücke 21
80639 München (DE)**

(54) **METHOD FOR CALCULATING ROUTE OF PREPREG TAPE**

(57) Provided is a method for adhering and laminating a prepreg tape without wrinkles on different curved surfaces, comprising: an exploring vector computing step (S101) in which an exploring vector (SV) along the expected direction of adhesion (V(i)) of the prepreg tape on the plane (S) of the prepreg tape is computed with an arbitrary initial coordinate (p0) as a starting point, the exploring vector (SV) serving as a scalar of a predetermined quantity of small amount ($\Delta a$); and a foot computing step (S102) in which the foot of a perpendicular line $p_{temp1-3}(i, j, k)$ leading from an end point (pe) of the computed exploring vector (SV) to the plane (S) is computed. A new exploring vector (SV) is computed based on the starting point of the exploring vector (SV) and the foot of the perpendicular line $p_{temp1-3}(i, j, k)$ until a predetermined termination condition is realized. The present invention also comprises navigating steps (S100 to S125) in which the exploring vector computing step (S101) is repeated based on the new exploring vector (SV) with the foot of the perpendicular line $p_{temp1-3}(i, j, k)$ serving as the initial point of the next computing.

FIG. 7

## Description

Technical Field

The present invention relates to a route computing method of a prepreg tape.

Background Art

The use of a composite material, particularly the use of a prepreg tape obtained by impregnating a fiber material with resin is growing in a variety of industries, including automotive, marine, and aerospace industries. The prepreg tape is adhered to a surface of a subject such as a mold configuring the casing of a vehicle (e.g., a mandrel) and laminated thereon.

A tape lay-up machine configured to automatically perform adhesion operations is classified into a flat surface lay-up machine and a curved surface lay-up machine. The flat surface lay-up machine is used for the stringer of an aircraft or the like, because the control of the flat surface lay-up machine when the prepreg tape is adhered is easy. In contrast, the curved surface lay-up machine has tendency to occur a slack, so that a wrinkle is often formed when the prepreg tape is adhered (laminated). The solution to the occurrence of the slack or the formation of the wrinkle remained as a difficult problem. In a case where the lay-up machine cannot be used, the prepreg tape is manually laminated by necessity. Therefore, in order to effectively prevent the formation of the wrinkle, there is a need for a method to be feasible to compute a tape path (also referred to as a "lay-up tape path") suitable for the curved surface.

To satisfy the need, Patent Document 1, for example, discloses the method for computing the tape path in order to adhere a composite material to the curved surface. The Patent Document 1 employs a method of mapping the three-dimensional curved surface of a product to be manufactured including the boundary of the curved surface to a two-dimensional criterion plane, computing a tape path on the criterion plane, and converting coordinates of the path into three-dimensional coordinates to obtain final coordinates.

Patent Document 1: Japanese Patent Application Laid-open No. 2007-185947

Summary of the Invention

Problems to be solved by the invention

However, the method of Patent Document 1 was insufficient to resolve the slack or wrinkle.

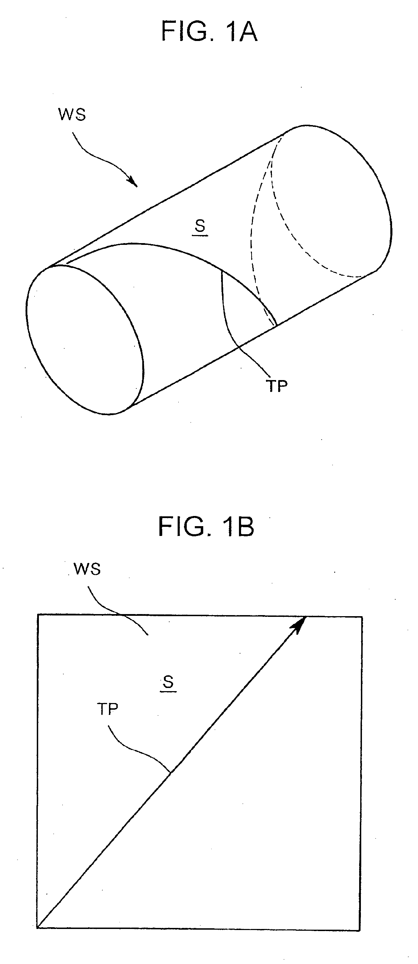

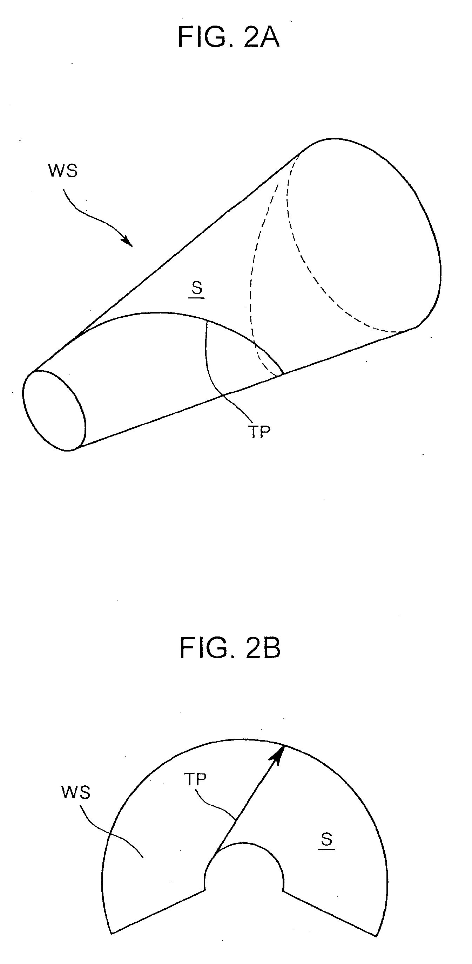

Referring to Figs. 1A and 1B and Figs. 2A and 2B, in a case where the curved surface of a product WS to be processed is cylindrical or conical as shown in Fig. 1A or 2A, the curved surface S of the product WS can be developed into a plane relatively accurately as shown in Figs. 1B and 2B. In this case, if a path having the shortest distance is calculated on the plane and the tape path is defined, the path having the shortest distance on the plane will be a substantially strait line, so that it becomes possible to adhere the prepreg tape with uniform load distribution over the entire area of the prepreg tape in a width direction.

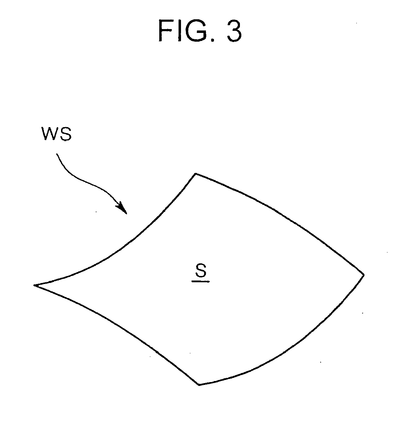

However there includes in a plenty of current products WS which has an intricately curved surface S, as shown in Fig. 3. Since the curved surface S is difficult to be developed into an accurate two-dimensional plane, automation has not been feasible.

The present invention has been made in view of the above problem, and an object of the present invention is to provide a method for computing the prepreg tape path capable of adhering and laminating the prepreg tape to and on various curved surfaces without forming the wrinkle.

Means to solve the Problem

In order to solve the above problem, the present invention is a route computing method of a prepreg tape for automatically computing a prepreg tape adhesion path, comprising: a three-dimensional data reading step of reading three-dimensional data on an adhesion surface of the tape; a criterion lay-up path setting step of setting a criterion lay-up path along an adhesion direction of the prepreg tape to be adhered in stored three-dimensional data; and an adjacent lay-up path setting step of setting an adjacent lay-up path that is adjacent to the criterion lay-up path, the adjacent lay-up path is set based on the criterion lay-up path set in the criterion lay-up path setting step, wherein each of the lay-up path setting steps includes: an exploring vector computing step of defining an arbitrary initial coordinate provided in stored three-dimensional data used as a start point, and computing an exploring vector having a small amount from the start point based on the adhesion direction of the prepreg tape to be adhered on the adhesion surface of the prepreg tape; and a foot computing step of computing a foot of perpendicular from a terminal point of the computed exploring vector to the adhesion surface, the method further comprises a navigating step of computing a new exploring vector based on the foot of perpendicular and an initial point of the exploring vector, and repeating the exploring vector computing step based on the new exploring vector with the foot of perpendicular, until a specific termination condition is satisfied. In this aspect, it is possible to compute the exploring vector which advances in the adhesion direction of the prepreg tape by a small amount with the initial coordinate set on the adhesion surface having various curved surfaces used as the initial point by executing the navigating step, and recursively repeat the computing with the foot of perpendicular from the terminal point of the exploring vector to the adhesion surface used as the computing criterion. As a result, the direction of the exploring vector is adjusted so as to be along the curved surface every small movement amount and the point serving as the computing criterion becomes the criterion for accurately computing the path along the curved surface, and hence it becomes possible to accurately compute the path which extends along the curved surface and prevents the formation of the wrinkle in the prepreg tape by computing the path based on the initial points which are successively computed by the recursively repeated computing.

In a preferred aspect, the method further includes an initial coordinate setting step of computing a foot of perpendicular with respect to an adhesion surface from the initial coordinate, and setting the foot of perpendicular as the initial coordinate prior to the criterion lay-up path setting step. In this aspect, it is possible to accurately perform the computing, yet enhancing flexibility in the selection of the initial coordinate.

In a preferred aspect, the adjacent lay-up path setting step includes: a criterion point exploring step of exploring a criterion point serving as a computing criterion for an adjacent lay-up path to be computed, by executing the navigating step based on execution of defining a lay-up path serving as a computing base used as a criterion line, defining a plurality of points on the criterion line as a start point, and computing an exterior product of the exploring vector and the unit normal vector for defining a new exploring vector; and a criterion points connecting step of connecting the criterion points for computing the adjacent lay-up path, wherein the adjacent lay-up path setting step repeatedly executes the criterion point exploring step and the criterion points connecting step using the computed adjacent lay-up path as a criterion lay-up path for a next computing, until a specific termination condition is satisfied. In this aspect, in computing the adjacent lay-up path spaced apart from a given lay-up path by a specific interval, it is possible to accurately compute the interval from the lay-up path as a criterion to the next adjacent lay-up path along the curved surface of the adhesion surface. Since the adjacent lay-up path is set based on the accurately computed interval, overlapping of the prepreg tape adhered to a given lay-up path and the prepreg tape adhered to the next adjacent lay-up path can be prevented as much as possible, and the formation of a gap of an allowable value or more can also be prevented as much as possible.

In a preferred aspect, wherein, in a case where the adhesion surface is divided into one surface and other surface by the criterion lay-up path, the adjacent lay-up path setting step is configured to be executed by way of computing an adjacent lay-up path with respect to the one surface, and subsequently computing an adjacent lay-up path with respect to the other surface executing the navigating step from the criterion lay-up path upon defining a new exploring vector by reversing a vector obtained from the exterior product. In this aspect, since the adjacent lay-up path is computed for each of the surfaces divided by the criterion lay-up path, based on points on the criterion lay-up path, the computing error of each adjacent lay-up path can be reduced to 1/2.

In a preferred aspect, wherein the criterion point connecting step is configured to complete a temporary lay-up path by connecting each of the criterion points, and wherein further comprises a lay-up extension step of completing an adjacent lay-up path by extending an end portion of the temporary lay-up path to a boundary of the adhesion surface, in a case where an end portion of the computed temporary lay-up path does not reach a boundary of the adhesion surface, wherein the lay-up extension step executes the navigating step by way of defining a terminal point of the temporary lay-up path as a start point, and computing an exploring vector based on a movement direction vector with respect to the terminal point of the temporary lay-up path. In this aspect, since, in a case where the length of the temporary lay-up path computed by the criterion point connection step does not reach a specific length on the curved surface, it is possible to determine an accurate extension line from the end portion of the temporary lay-up path, thereby accurately computing the adjacent lay-up path longer than the lay-up path having served as the base for the adjacent lay-up path along the curved surface of the adhesion surface. "Computing an exploring vector based on a movement direction vector with respect to the terminal point of the temporary lay-up path" referrers to as a case where the movement direction vector is set as the exploring vector, or a case where a vector in a direction opposite to that of the movement direction vector is set as the exploring vector.

In a preferred aspect, wherein, in a case where the adhesion surface is intersected by the ridge line and a terminal point of the exploring vector exceeds the ridge line, the exploring vector computing is executed by way of computing a foot of perpendicular with respect to an adjacent surface, which is adjacent to an explored surface such that the adjacent surface and the explored surface are intersected with a ridge line, the exploring vector is computed by defining the foot of perpendicular as a criterion for next computing if the foot of perpendicular with respect to the adjacent surface exists, a foot of perpendicular on the ridge as a criterion for next computing is computed, on the other hand, if the foot of perpendicular on the adjacent surface does not exist. In this aspect, in a case where the adhesion path of the tape is computed on adhesion surfaces intersected with the ridge line, it becomes possible to compute the smooth adhesion path across the ridge line.

In a preferred aspect, wherein, in a case where a tape is to be laminated on the adhesion surface, the criterion lay-up path setting is executed by way of computing an offset amount, which corresponds to a thickness of the prepreg tape, along a normal to an adhesion surface passing through a foot of perpendicular determined from the initial coordinate, and computing a criterion lay-up path with a terminal point used as a start point of a next layer, and the exploring vector computing is executed by way of computing a foot of perpendicular with respect to the adhesion surface from a point serving as a computing criterion, and setting a point, which is offsetting by the thickness of the tape along a direction of the normal, to the adhesion surface which passes through the foot of perpendicular as a start point of next computing. In this aspect, since an initial point with respect to a plurality of layers are set based on an initial coordinate defined according to the adhesion surface, it is possible to obtain an accurate offset amount by thickness of laminated layers, thereby computing criterion lay-up paths or adjacent lay-up paths.

In a preferred aspect, in the exploring vector computing step, a foot of perpendicular to the adhesion surface is computed from a point serving as the computing criterion, and a point offset by thickness of the tape along a direction of the normal to the adhesion surface which passes through the foot of perpendicular is set as a start point of the next computing. In this aspect, it is possible to offset by the thickness of the prepreg tape relative to the adhesion surface to totalize the path, and hence it is possible to compute the precise path even in a case where the adhesion path of the tape adhered to a plurality of the layers is computed. Herein, the "point serving as the computing criterion" referrers to as an initial coordinate at the first stage of the computing. The initial point of the next exploring vector after the exploring vector is computed from the initial coordinate.

In a preferred aspect, in a case where the adhesion directions V (i) of the prepreg tape set in a plurality of the layers are duplicated, the coordinate of the initial coordinate in the upper layer is shifted in the width direction of the tape.

In a preferred aspect, in the criterion lay-up path setting step, after a first half lay-up path along the specific exploring vector set from the initial coordinate is computed, a second half lay-up path along the exploring vector in the direction opposite to the direction of the specific exploring vector set from the initial coordinate is computed, thereby the first half lay-up path and the second half lay-up path are connected to each other. In this aspect, with the initial coordinate used as the criterion, the criterion lay-up path is divided into the first half lay-up path and the second half lay-up path, and they are computed independently, and the computing error of each of the lay-up paths can be reduced to 1/2.

Effect of the Invention

Executing the navigating step, a point serving as the computing criterion becomes a criterion for accurately computing the path along the curved surface, so that a remarkable effect is achieved that it is possible to adhere and laminate the prepreg tape to and on various curved surfaces without forming the wrinkle.

Brief Description of the Drawings

Fig. 1A is a perspective view of a cylindrical product for explaining a tape lay-up path for a curved surface of a product to be processed.

Fig. 1B is a developed view of the cylindrical product for explaining the tape lay-up path for the curved surface of the product to be processed.

Fig. 2A is a perspective view of a conical product for explaining the tape lay-up path for the curved surface of the product to be processed.

Fig. 2B is a developed view of the conical product for explaining the tape lay-up path for the curved surface of the product to be processed.

Fig. 3 is a view for explaining the tape lay-up path for the curved surface of the product to be processed, and is a perspective view of the product having the curved surface.

Fig. 4 is a block diagram of a prepreg tape path computing device according to the present invention.

Fig. 5 is a perspective view showing a tape lay-up plan of a product having an adhesion surface.

Fig. 6 is a flowchart showing the entire flow according to the present invention.

Fig. 7 is a flowchart showing the operation of a navigating module as navigating steps.

Fig. 8 is a flowchart showing the subsequent part of Fig. 7.

Fig. 9A is an explanatory view showing a search state on a curved surface in accordance with the navigating module.

Fig. 9B is an explanatory view showing the search state on a curved surface which is offset from the curved surface in accordance with the navigating module.

Fig. 10 is an explanatory view showing the search state in accordance with the navigating module.

Fig. 11 is an explanatory view showing the search state in accordance with the navigating module.

Fig. 12 is a flowchart showing a subroutine of Fig. 6.

Fig. 13A is an explanatory view of an adhesion surface for explaining the execution result of the flowchart of Fig. 12 in a case where an initial coordinate is on the curved surface.

Fig. 13B is an explanatory view of the adhesion surface for explaining the execution result of the flowchart of Fig. 12 in a case where the initial coordinate is floating from the curved surface.

Fig. 13C is an explanatory view of the adhesion surface for explaining the execution result of the flowchart of Fig. 12 in a case where the initial coordinate is offset from the curved surface.

Fig. 14 is a perspective view of the adhesion surface for explaining the execution result of the flowchart of Fig. 12.

Fig. 15 is a perspective view of the adhesion surface for explaining the execution result of the flowchart of Fig. 12.

Fig. 16 is a perspective view of the adhesion surface for explaining the execution result of the flowchart of Fig. 12.

Fig. 17 is a perspective view of the adhesion surface for explaining the execution result of the flowchart of Fig. 12.

Fig. 18 is a perspective view of the adhesion surface for explaining the execution result of the flowchart of Fig. 12.

Fig. 19 is a flowchart showing the subsequent part of Fig. 12.

Fig. 20 is a perspective view of the adhesion surface for explaining the execution result of the flowchart of Fig. 19.

Fig. 21 is a perspective view of the adhesion surface for explaining the execution result of the flowchart of Fig. 19.

Fig. 22 is a perspective view of the adhesion surface for explaining the execution result of the flowchart of Fig. 19.

Fig. 23 is a flowchart showing the subsequent part of Fig. 19.

Fig. 24 is a perspective view of the adhesion surface for explaining the execution result of the flowchart of Fig. 23.

Fig. 25 is a perspective view of the adhesion surface for explaining the execution result of the flowchart of Fig. 23.

Fig. 26 is a flowchart showing the subsequent part of Fig. 23.

Best Mode for Carrying Out the Invention

Hereinbelow, a preferred embodiment of the present invention will be described with criterion to the accompanying drawings.

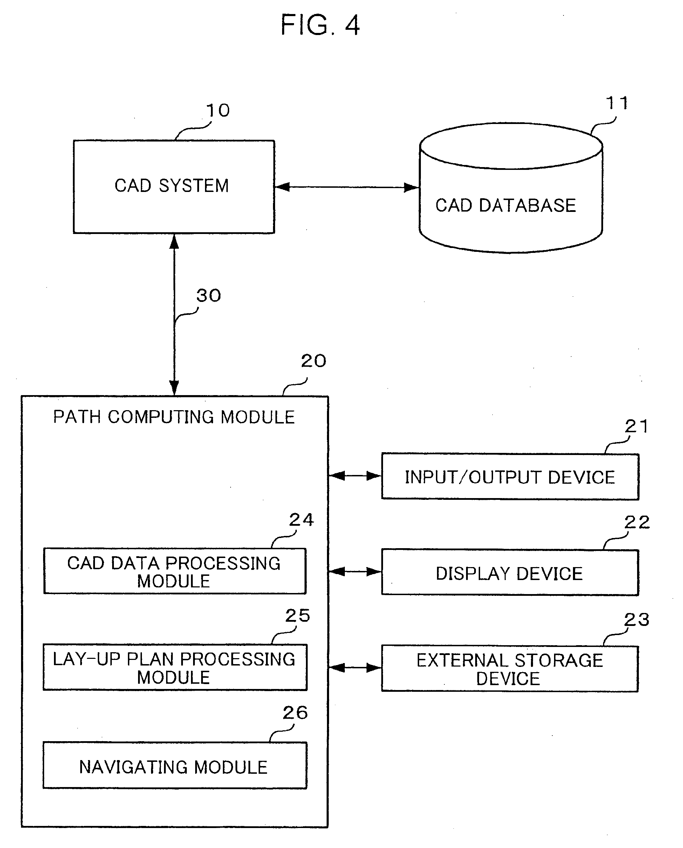

First, referring to Fig. 4, the system according to the present invention comprises a CAD system 10 and a path computing module 20 connected to the CAD system 10 such that data can be exchanged between them.

The CAD system 10 is connected to a CAD database 11 in which data on products to which a prepreg tape is adhered is accumulated. The CAD system 10 is capable of transmitting CAD data stored in the CAD database 11 to the path computing module 20 via an interface (or a network) . In general, the CAD data is stored in a format which allows defining a three-dimensional curved surface, such as NURBS (Non-Uniform Rational B-Splines) or the like.

The path computing module 20 is a logic module implemented by a computer such as a factory computer or the like. In addition to a CPU, a ROM, and a RAM which are not shown, the hardware includes such as an input/output device 21, a display device 22, and an external storage device 23.

The path computing module 20 logically has a CAD data operation module 24 which executes reading of data from the CAD system 10 or the like, a lay-up plan processing module 25 which processes a to be adhered lay-up plan on inputted CAD data, and a navigating module 26 which computes the shortest path (hereinafter, this shortest path is also referred to as a "natural path") of the prepreg tape on a surface including a flat surface and a curved surface based on the lay-up plan processing module 25. These modules are implemented by a combination of hardware resources configuring the path computing module 20 and software resources executed by the hardware resources (e.g. , a source code, an object code, or a programming code).

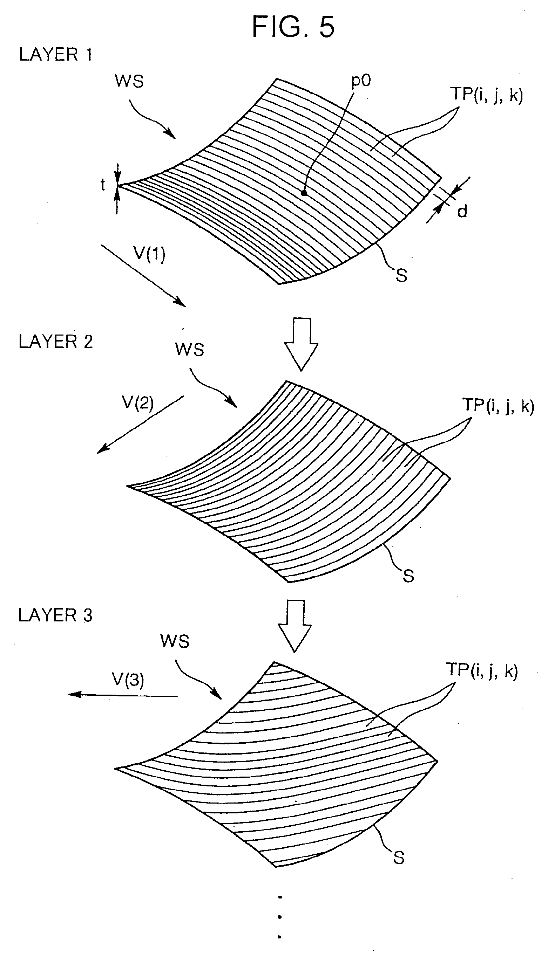

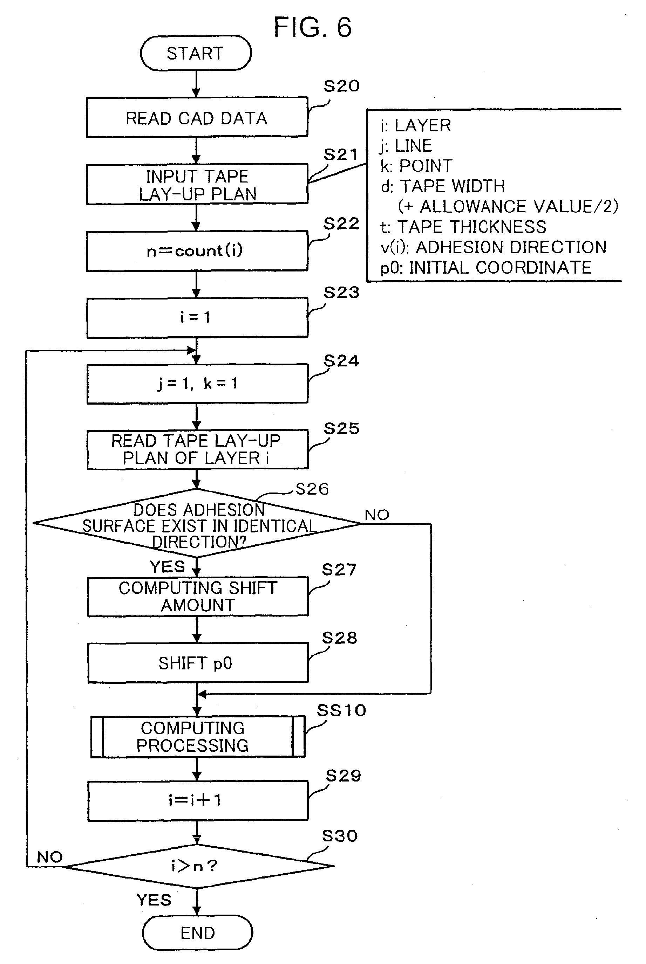

Referring to Fig. 5, a work WS shown in the drawing as an example is a rectangular component configuring a vehicle body component. In a manufacturing process of this component, an adhesion direction V (i) is inputted to a curved surface S defined by a mandrel (not shown) for each layer i. Specifically, the manufacturing process is configured to execute a setting for forming tape layers (tape lay-up) by changing a path for each layer such that the prepreg tape is firstly adhered along a V (1) direction with respect to one side of the work, the prepreg tape is adhered secondly along a path V (2) orthogonal to the first path V(1), and the prepreg tape is adhered further along a path V(3) which intersects the first path V (1) at an angle of 45°. (a setting requirement related to this prepreg tape adhesion procedure is referred to as a "tape lay-up plan".) In this case, the path computing module 20 shown in Fig. 4 computes a tape adhesion path suitable for the tape lay-up plan of the work according to flowcharts of Fig. 6 and subsequent thereto.

In the tape lay-up plan, an initial coordinate p0 is set only for the first layer i (layer 1) . As will be described later in detail, the initial coordinate p0 is a coordinate serving as the base of computing of a lay-up path in all layers i.

Referring to Fig. 6, first, the path computing module 20 reads data on the work from the CAD system 10 with the CAD data operation module 24 (step S20). In the present embodiment, this step S20 is a three-dimensional data reading step.

Next, the input process of the tape lay-up plan as shown for example in Fig. 5 is executed (step S21) . In the step S21, the lay-up plan processing module 25 is executed, and an input screen is displayed on the display device 22 by a GUI. A user manipulates the input/output device 21 according to the instruction of the input screen, and he/she inputs the tape lay-up plan. In this step S21, the user inputs the width d of the tape adhered to the work, the thickness t of the tape, the adhesion direction V(i) of the prepreg tape for each layer, and the initial coordinate p0 for computations. When the initial coordinate p0 is inputted, a CAD drawing showing the work may be displayed on the screen, in order to allow the user to designate an arbitrary point desired by the user using the input/output device 21. The lay-up plan processing module 25 records the inputted data in a memory or the external storage device 23, thereby utilizing the data in subsequent processing.

In addition, the lay-up plan processing module 25 counts the number of layers n of the tape lay-up at a stage where the input is completed (step S22). Next, the initial setting of variables i, j, and k of the lay-up path which serve as a computing criterion is performed (steps S23 and S24). In the present embodiment, a plurality of the lay-up paths are set for each layer, such that the variable i related to the layer is set, the variable j related to the lay-up path is set, and the variable k related to the configuration of the lay-up path is set. Thus, all of the computed coordinates can be three-dimensionally determined uniquely.

Next, the tape lay-up plan set for the layer i is read (step S25). By this reading, the initial coordinate p0, the tape width d, the tape thickness t, and the adhesion direction V(i) of the prepreg tape for each layer i are specified.

Subsequently, the lay-up plan processing module 25 explores whether or not the adhesion direction V(i) related to the read layer i and the adhesion direction V(i) set for another layer i which is already computed overlap one another (step S26). In a case where the layer i having the identical adhesion direction V (i) is detected, the module computes a position displaced from the initial coordinate p0 of a criterion lay-up path TPs set for the layer i by 1/2 of the width d along the width direction of the prepreg tape (step S27), and the coordinate of the position is set as a new initial coordinate p0 (step S28). With this, the prepreg tape of the layer i for which the lay-up path is already computed is displaced from the prepreg tape of the layer i for which the lay-up path is not computed yet by 1/2 of the width d in the width direction, and hence the work to be manufactured has a solid structure which prevents the work from being collapsed.

Next, a computing processing subroutine with respect to the layer i is executed (step SS10). When the computing processing subroutine is executed, the variable i of the layer is incremented (step S29), and the variable i of the layer incremented is compared with the number of layers n counted in the step S22 (Step S30). In a case where the variable i of the layer is in as most the number of layers n, the flow returns to the step S24 and the above-described processing is repeated and, in a case where the variable i of the layer is more than the number of layers n, the processing is ended.

In the computing processing subroutine, the criterion lay-up path TPs is computed for each layer i, and an adjacent lay-up path TPn adjacent to the criterion lay-up path TPs at an equal interval is then computed. When the adjacent lay-up path TPn is computed, the lay-up path which has already computed is used as a criterion, and coordinates spaced apart from the lay-up path serving as the base by the equal interval are computed. Consequently, even in a case where the curved surface S as the adhesion surface is intricately undulated, it becomes possible to compute the lay-up path in which the prepreg tape can be adhered along the undulation in a state where laps and wrinkles are less likely to occur. In the present embodiment, in order to implement more precise computing, the navigating module 26 is called throughout the individual steps. The navigating module 26 is a function group for computing the natural path on the intricately curved surface, and is capable of the following computing.

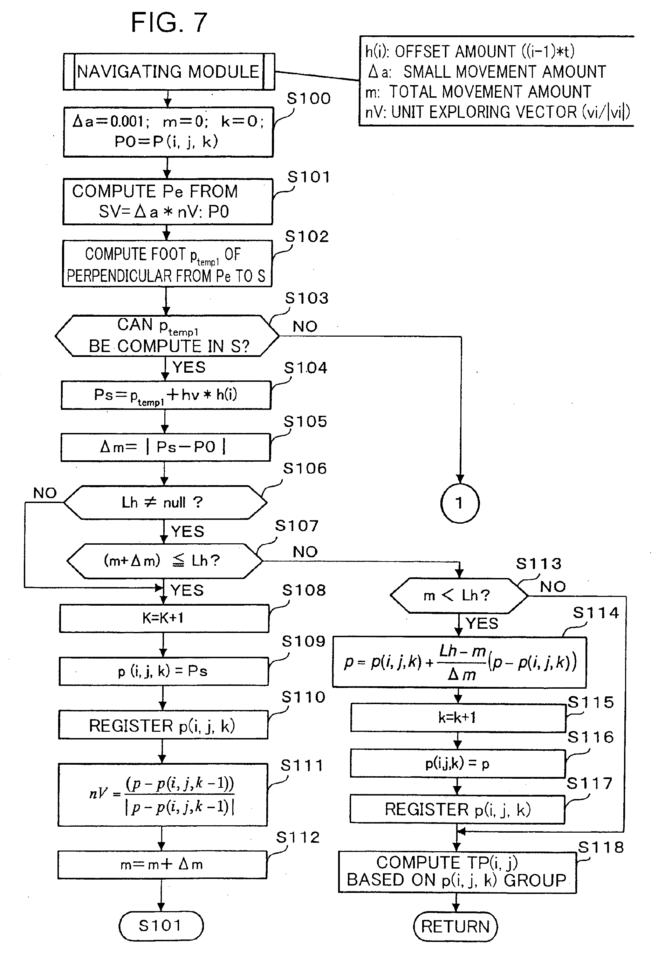

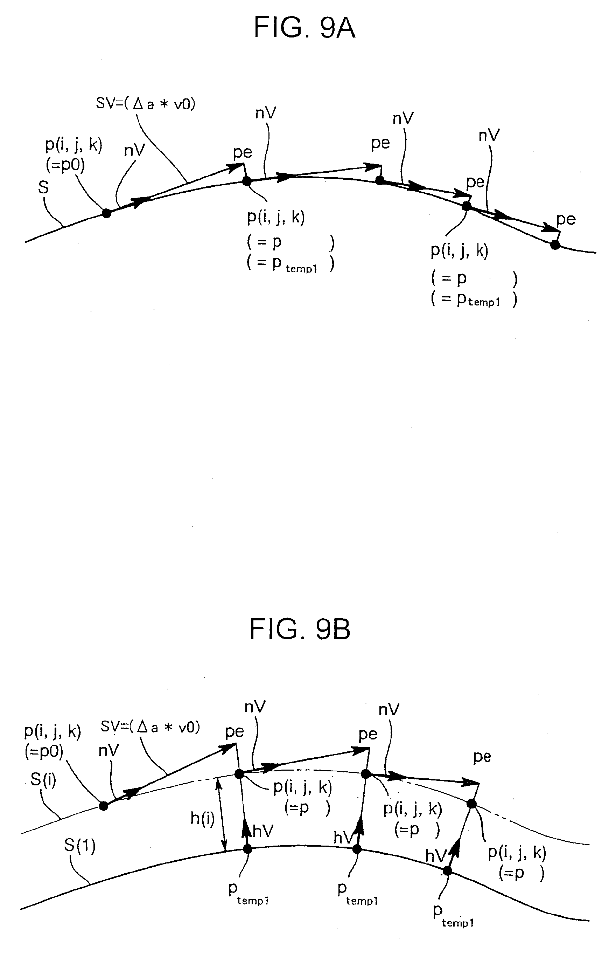

Referring to Fig. 7 and Figs. 9A and 9B, the navigating module 26 includes an offset amount h(i), a small movement amount $\Delta a$, a total movement amount m, and a unit exploring vector nV as arguments. The offset amount h(i) refers to a flotation amount in the direction of the normal to the curved surface S set in consideration of the thickness t of the prepreg tape, wherein a variable (derivative) is computed by (i - 1) x t for the i-th layer i. The small movement amount $\Delta a$ refers to the movement amount of the coordinate to be searched for, which is set to, e.g., 0.001 mm. The total movement amount m refers to the total value of the computed search path. The unit exploring vector nV refers to a unit vector for computing a vector in an exploring direction of the lay-up path (an exploring vector SV), and is computed by using the adhesion direction V(i) as a criterion. The unit exploring vector nV is set so as to be in contact with the curved surface S (see Fig. 9A) as much as possible. The values of the arguments are appropriately changed according to a program which calls the navigating module 26, or according to the type of a computed offset path.

When the navigating module 26 is called, an initial setting of the arguments is firstly executed (step S100). In this initial setting, the small movement amount $\Delta a$ is set to 0. 001 mm, and the total movement amount m is set to 0.0 mm. It should be appreciated that the initial setting is configured to be able to change in an appropriate manner by displaying an initial setting screen using a GUI by the operation of the user.

Next, a movement point pe is computed (step S101). In this processing, the exploring vector SV is obtained by the product of the small movement amount $\Delta a$ and the unit exploring vector nV, and a terminal point pe of the exploring vector SV is computed by using a point p(i, j, k) serving as the computing base as an initial point. The point p (i, j, k) serving as the computing base is set by the program which calls the navigating module 26. For example, in a case where the computing of the criterion lay-up path TPs is started, the initial value of p(i, j, k) corresponds to the initial coordinate p0. Next, a foot $p_{temp1}$ of a perpendicular from the computed terminal point pe to the curved surface S is computed (step S102), and it is verified whether or not $p_{temp1}$ is a coordinate which can be computed (step S103).

In a case where $p_{temp1}$ is a computable coordinate, the foot $p_{temp1}$ of the perpendicular + (hV * h(i)) is computed (step S104). Herein, hV is a normal unit vector to the curved surface S which passes through $p_{temp1}$ and h (i) is the variable computed by (i - 1) x t, and hence, in the first layer i, the foot $p_{temp1}$ of the perpendicular is the point p (see Fig. 9A) . On the other hand, in the second or subsequent layer i, h is larger than 0, and hence the point p to be computed corresponds to a coordinate floated from the foot $p_{temp1}$ of the perpendicular in the direction of the normal by h(i) as shown in Fig. 9B.

Subsequently, the movement amount $\Delta$m from the start point p (i, j, k) to the computed point p is computed (step S105).

Then, it is checked whether or not a set value Lh is set (step S106). As will be described later in detail, the set value Lh is a value for computing the interval from the coordinate serving as a criterion to a coordinate serving as a computing target when the coordinate serving as a computing criterion of the adjacent lay-up path is computed using the navigating module 26. The set value is set by a program which calls the navigating module 26.

In cases where the set value Lh is not set, null is set, or value Lh is set but is smaller than the updated value (m + $\Delta$m) of the total movement amount m (step S107), the module increments the variable k (step S108).

The module sets the coordinate of the computed point p as p (i, j, k) (step S109), and the coordinate p (i, j, k) is registered (step S110).

Thereafter, a next unit exploring vector nV is computed by the following expression (step S111) :

$$nV = \frac{(p - p(i, j, k - 1))}{|p - p(i, j, k - 1)|} \qquad ...(1)$$

and the total movement amount m is incremented with the movement amount $\Delta$m (step S112). Thereafter, the flow returns to the step S101, and the above-described steps are repeated.

In the step S107, in a case where the set value Lh exceeds the updated value (m + $\Delta$m) of the total movement amount m, it is judged whether or not the total movement amount m is less than the set value Lh (step S113) . In a case where the total movement amount m is less than the set value Lh, the terminal point of the set value Lh is determined by the following expression (step S114):

$$p = p(i, j, k) + \frac{Lh - m}{\Delta m}(p - p(i, j, k)) \qquad ...(2)$$

the variable k of the lay-up path is incremented (step S115), the computed coordinate is set as p (i, j, k) (step S116), and the coordinate p(i, j, k) is registered (step S117). In a case where the set value Lh is set, the natural path is accurately calculated until the terminal point thereof by the steps S113 to S117. Thereafter, the module computes the natural path TP (i, j) (step S118) based on the computed points p (i, j, k), and the flow returns to the main program. It should be appreciated that, in a case where the total movement amount m is not less than the set value Lh in the step S113, the flow moves to the step S118.

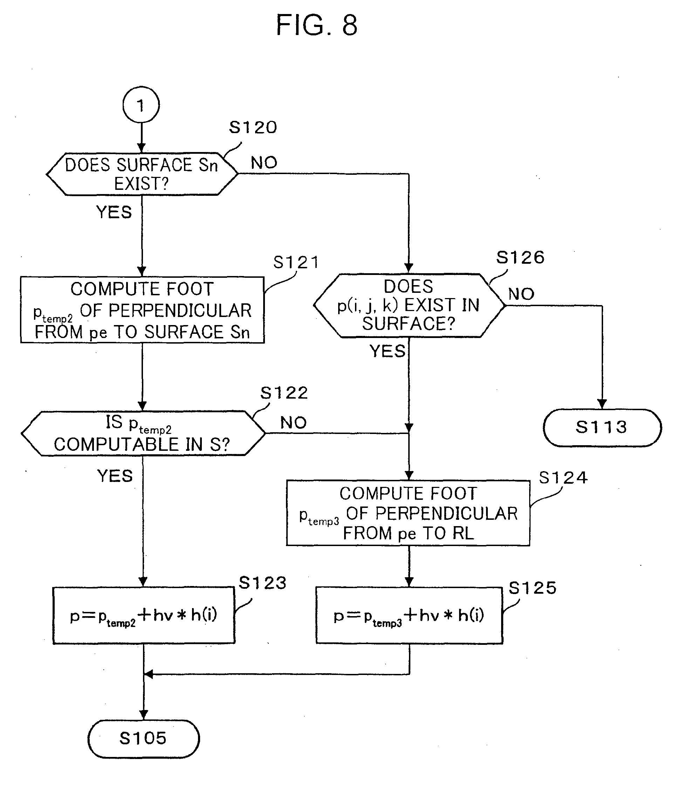

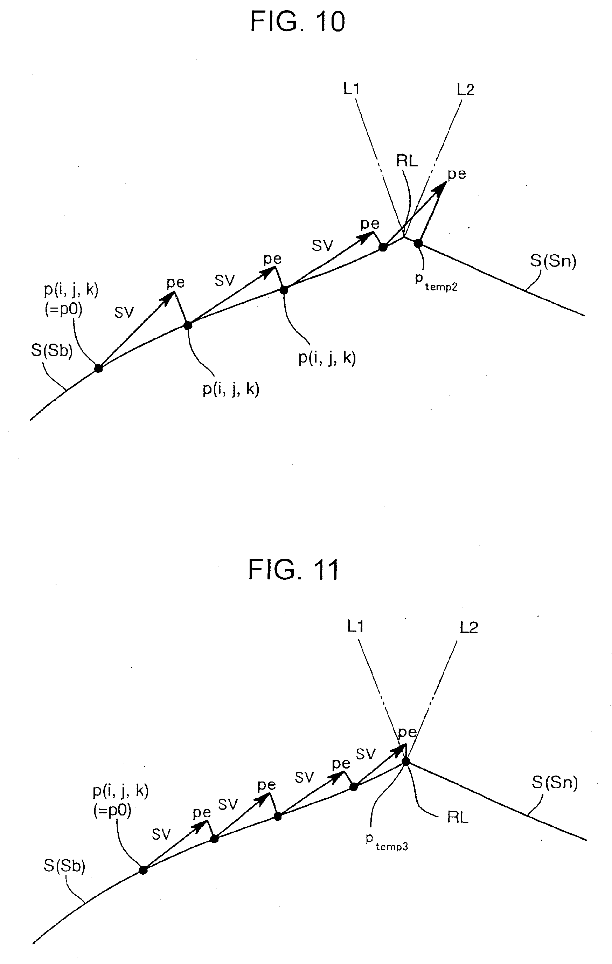

Next, a description will be given of a case where the foot $p_{temp1}$ of the perpendicular cannot be computed in the step S103 with criterion to Figs. 8 and 10.

As shown in Fig. 10, in a case where a ridge line RL exists on the curved surface S and the curved surface S is divided into two surfaces Sb and Sn, and the terminal point pe of the exploring vector SV computed on the surface Sb passes through a plane L1 on the ridge line RL orthogonal to the surface Sb, it is not possible to compute the foot $p_{temp1}$ of the perpendicular on the surface Sb. To cope with this, where $p_{temp1}$ is incomputable, the module firstly examines whether or not the adjacent surface Sn exists (step S120), as shown in Fig. 8. If the surface Sn exists, the module computes a foot $p_{temp2}$ of the perpendicular to the surface Sn from the explored terminal point pe (step S121) . The module further examines whether or not the foot $p_{temp2}$ of the perpendicular to the surface Sn is computable (step S122) . In a case where the determination is computable (e.g., as shown in Fig. 10, in a case where the terminal point pe exists in an area between the surface Sn and the plane L2 on the ridge line RL orthogonal to the surface Sn), the point p is computed based on the foot $p_{temp2}$ of the perpendicular (step S123), and the flow returns to the step S105. Herein, hv in the step S123 is a normal unit vector to the surface Sn at $p_{temp2}$.

On the other hand, as shown in Fig. 11, in a case where the terminal point pe of the exploring vector SV exists between the planes L1 and L2, the foot of perpendicular is incomputable to either surface Sb or Sn. In this case, the module determines in the step S122 that the foot $p_{temp2}$ of the perpendicular is incomputable, and the module computes a foot $p_{temp3}$ of a perpendicular from the terminal point pe to the ridge line RL(step S124). A point p is then computed based on the foot $p_{temp3}$ of the perpendicular (step S125), and the step is moved on to the step S105 . The hv in the step S125 designates a vertical unit vector toward the terminal point pe of the exploring vector SV from $p_{temp3}$.

It should be appreciated that, in the step S120, where the adjacent surface Sn does not exist, the terminal point pe of the exploring vector SV exceeds the boundary of the surface s, and hence, in this case, it is verified whether or not the start point p(i, j, k) exists in the surface (step S126) and, in a case where the start point p is in the surface s, RL is determined as the boundary, and the flow moves to the step S124. On the other hand, in a case where the start point p(i, j, k) does not exist in the surface (in a case where the start point is on the boundary), the flow moves on to the step S113, and the processing is ended.

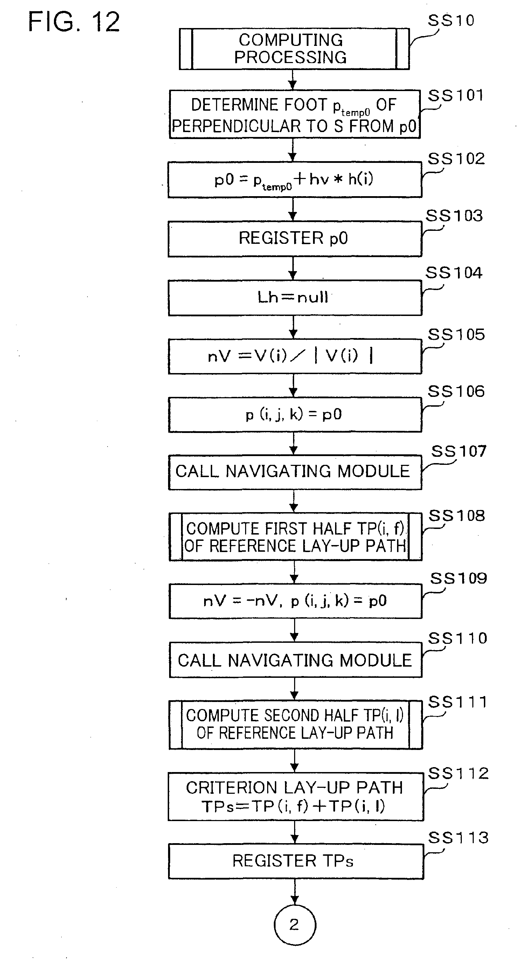

Next, a description will be given of the specific example of the computing processing subroutine (the step SS10) of Fig. 12, where the navigating module 26 executes the above-described processing.

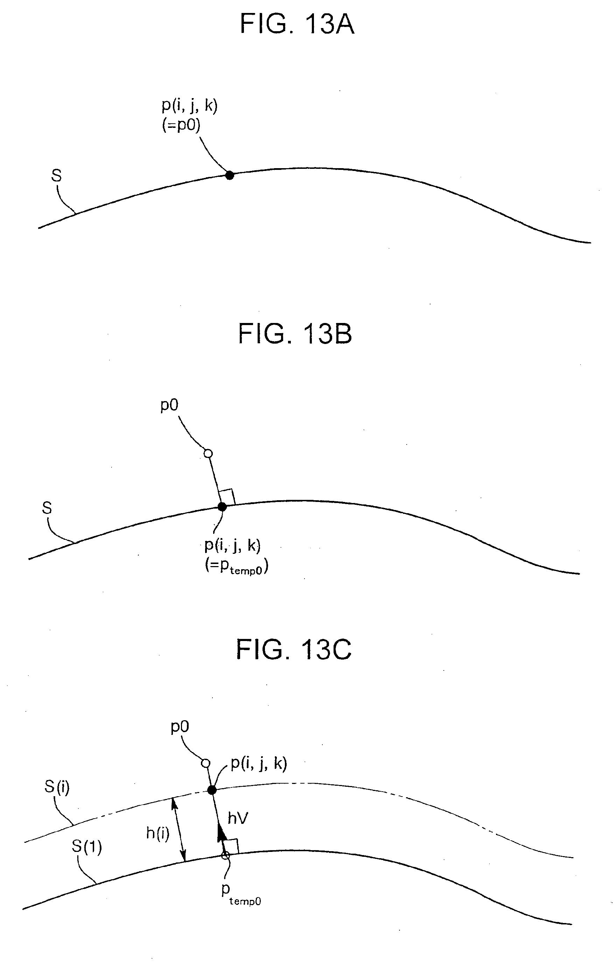

Referring to Figs. 12, 13A, 13B, and 13C, where the computing processing subroutine is executed, initial coordinate setting steps (SS101 to SS103) are initially executed. In the initial coordinate setting steps, a foot $p_{temp0}$ of the perpendicular to the curved surface S is computed from the initial coordinate p0 given in the step S21 of Fig. 6 (step SS101), $p_{temp0} + (hV * h(i))$ is further computed, and p0 is newly set (step SS102) . Since hV is the normal unit vector to the curved surface S which passes through $p_{temp0}$ and h (i) is the variable computed by (i - 1) x t, the layer i to be computed is a first layer and an initial coordinate p0 is the same coordinate (see Fig. 13A), in a case where the original initial coordinate p0 exists on the curved surface S. Meanwhile, in a case where the set initial coordinate p0 is floating from the curved surface S and the layer i to be computed is the first layer, the initial coordinate p0 is updated to the foot $p_{temp0}$ of the perpendicular (see Fig. 13B). Further, in a case where the layer i to be computed is the second or subsequent layer, the foot $P_{temp0}$ of the perpendicular is offset by h(i), after the initial coordinate is updated to the foot $p_{temp0}$ of the perpendicular (see Fig. 13C) . As a result, the initial coordinate p0 as the initial computing base of the navigating module 26 and the curved surface S are associated with each other extremely accurately.

Next, criterion lay-up path setting steps are executed.

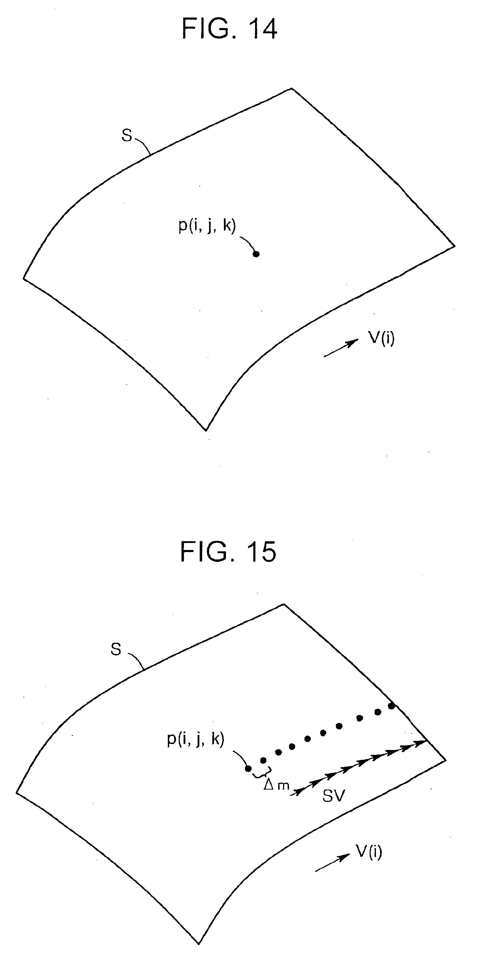

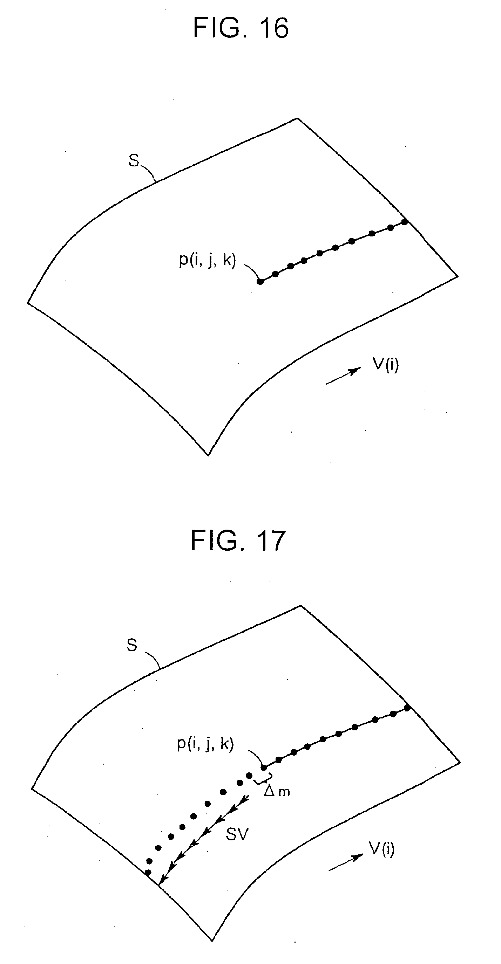

As shown in Fig. 12, in the criterion lay-up path setting steps, first, the setting of the arguments for executing the navigating module 26 is executed. Specifically, Lh is set to the null value (step SS104), the unit exploring vector nV is defined based on the adhesion direction V(i) of the prepreg tape (step SS105), and the start point p(i, j, k) is set as the initial coordinate p0 (step SS106). With this, the navigating module 26 searches for the lay-up path up to the boundary of the curved surface S in an nV direction with p0 used as the start point. In the present embodiment, the lay-up path obtained by this search is a first half lay-up path TP (i, f). Subsequently, the navigating module 26 is called (step SS107), and the first half lay-up path TP(i, f) is computed by executing the navigating module 26 based on the setting of the arguments described above (step SS108). By this computing, the start point p(i, j, k) is set on the curved surface S as shown in Fig. 14, the coordinate p(i, j, k) spaced apart from the set start point p (i, j, k) by an interval $\Delta m$ is then registered successively as shown in Fig. 15, and the first half lay-up path TP (i, f) is computed up to the boundary of the curved surface S as shown in Fig. 16.

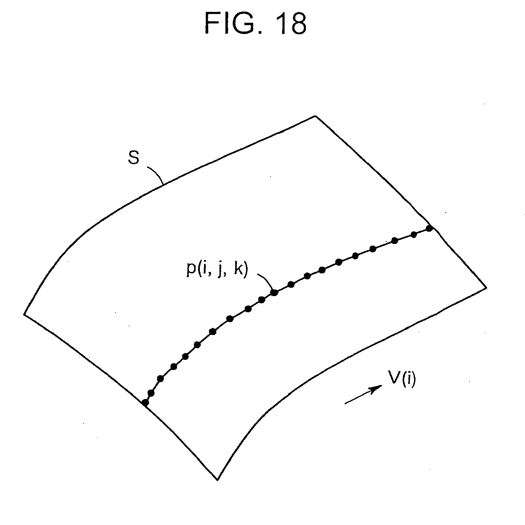

Subsequently, when the processing of the navigating module 26 is terminated, i.e., when the step SS108 is terminated, the direction of the unit exploring vector nV is reversed and the start point is changed back to the initial coordinate p0 (step SS109). Then, the navigating module 26 is called again (step SS110), and a second half lay-up path TP(i, 1) is computed (step SS111). By this computing, the coordinate p (i, j, k) spaced apart from the point p(i, j, k) having the initial coordinate p0 as the start point by the interval $\Delta m$, as shown in Figs. 17 and 18, is successively recorded, and the second half lay-up path TP(i, 1) is computed up to the boundary of the curved surface S.

Next, the computed first half lay-up path TP (i, f) and the computed second half lay-up path TP (i, 1) are connected to each other thereby computing the criterion lay-up path TPs (step SS112). The criterion lay-up path TPs is then recorded (step SS113).

Next, a description will be given of adjacent lay-up path setting steps in which the adjacent lay-up path TPn adjacent to the criterion lay-up path is set based on the registered criterion lay-up path TPs.

In order to prevent the prepreg tapes from overlapping one another, it is necessary to compute accurately an interval between the set lay-up path and the adjacent lay-up path needs. Although this computing is relatively easy in a case where the adhesion surface is a flat surface, it is said that the computation would be extremely difficult in a case where the adhesion surface is a curved surface. In the present embodiment, in order to compute a plurality of the lay-up paths on the curved surface, there is adopted a step in which an opposing interval from the computed lay-up path is computed using the navigating module 26, and, later on, the adjacent lay-up path TPn is computed by connecting the computed opposing intervals.

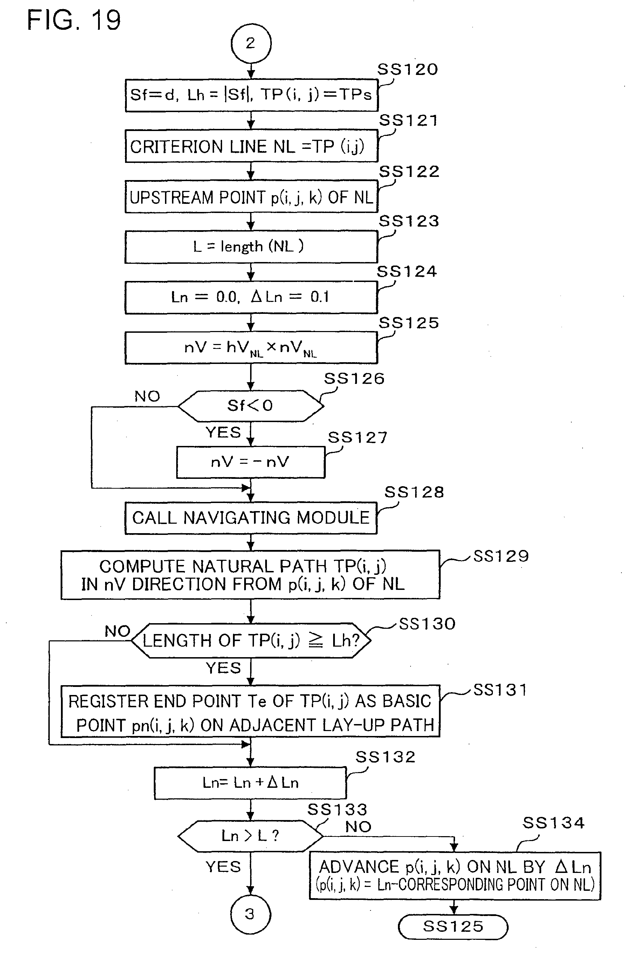

First, referring to Fig. 19, the width d of the prepreg tape is set as an exploring value Sf, and an absolute value of the exploring value Sf is set as the set value Lh (step SS120), in order to compute the opposing interval from the computed criterion lay-up path TPs using the navigating module 26. The exploring value Sf serves as a flag that sets an exploring direction of the criterion lay-up. As described above, the set value Lh serves as a value for computing an interval from a coordinate (or a start point p(i, j, k)) serving as the base to a coordinate Te as the computing target, at a time when the navigating module 26 computes a coordinate serving as a criterion for computing the adjacent lay-up path TPn. At this stage, the criterion lay-up path TPs is defined as TP(i, j).

Next, TP(i, j) is defined as a criterion line NL (step SS121) . In an upstream point on the criterion line NL (a point on the upstream side in the adhesion direction; the point is set on the boundary in the adhesion direction V (i) of the prepreg tape), p (i, j, k) is defined as a start point p(i, j, k). Subsequently, the entire length of the criterion line NL is indicated by L (step SS123), the interval which divides the criterion line NL is indicated by $\Delta$Ln, and a total interval Ln is reset to 0 (step SS124).

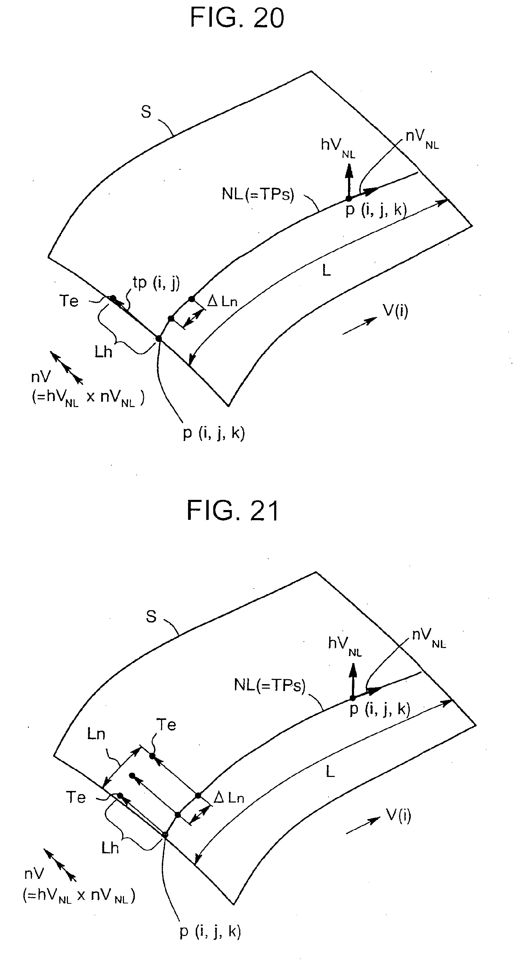

Then, a unit exploring vector nV is determined by the exterior product of a unit normal vector $hV_{NL}$ (the suffix NL denotes a coordinate p(i, j, k) on the criterion line NL, the same hereinafter) at p(i, j, k) on the curved surface S and unit exploring vector $nV_{NL}$ p(i, j, k) (step SS125). As shown in Fig. 20, it is possible to set the unit exploring vector nV along the curved surface S orthogonal to the unit exploring vector $nV_{NL}$ at each point p (i, j, k) set on the criterion line NL.

Next, the direction of the unit exploring vector nV is determined based on the exploring value Sf (step SS126). In a case where the value of the exploring value Sf is negative, the value of the unit exploring vector nV is inverted (step SS127).

Subsequently, the navigating module 26 is called (step SS128), and the natural path TP(i, j) along the nV direction from p(i, j, k) of the criterion line NL is computed (step SS129).

At this stage, as shown in Fig. 21, maintaining accurate intervals, the navigating module 26 enables to calculate natural paths TP(i, j) from the start point p(i, j, k) set on the criterion line NL, and the terminal point Te. Starting the computing, the exploring vector SV is set on the curved surface S along the direction orthogonal to the adhesion direction V(i) of the prepreg tape, and the start point p(i, j, k) is successively updated. When the natural path TP(i, j) is computed by the navigating module 26 in the step S118 (see Fig. 7) and the control returns to the flow of Fig. 19, the lay-up plan processing module 25 judges whether or not the computed natural path TP(i, j) is not less than the set value Lh (step SS130). Where Lh is set in processes by the navigating module 26, there are cases divided into two: a case where the computed natural path TP (i, j) is not less than the set value Lh; and a case where the computed natural path TP (i, j) is ended at some midpoint of the set value Lh. Therefore, the judgment is executed in step SS130 in order to register only the natural path TP(i, j) which is determined to be not less than the set value Lh, and the lay-up plan processing module 25 registers the terminal point Te of only the natural path TP (i, j) not less than the set value Lh as the basic point pn (i, j, k) of the adjacent lay-up path TPn (step SS131). Thus, the terminal points Te of solely the natural paths TP (i, j) not less than the set value Lh serve as the computing criterion for the adjacent lay-up path TPn.

Next, the total interval Ln is updated with a division interval $\Delta$Ln (step SS132), and it is judged whether or not the total interval Ln exceeds the entire length of the criterion line NL (step SS133). If the total interval Ln exceeds the entire length of the criterion line NL, the flow moves to the next step. If the total interval Ln is not more than the entire length of the criterion line NL, the start point p (i, j , k) is updated with the division interval $\Delta$Ln (step SS134), the flow moves to the step SS125, and the above-described processing is repeated.

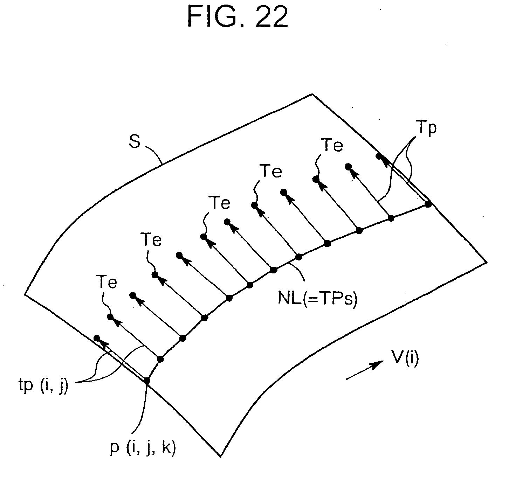

Thus, a large number of the start points p(i, j, k) are set for each criterion line NL, the terminal point Te having the opposing interval accurately computed by the navigating module 26 is computed for each set start point p(i, j, k), and the terminal point Te present in the curved surface S is registered, as shown in Fig. 22.

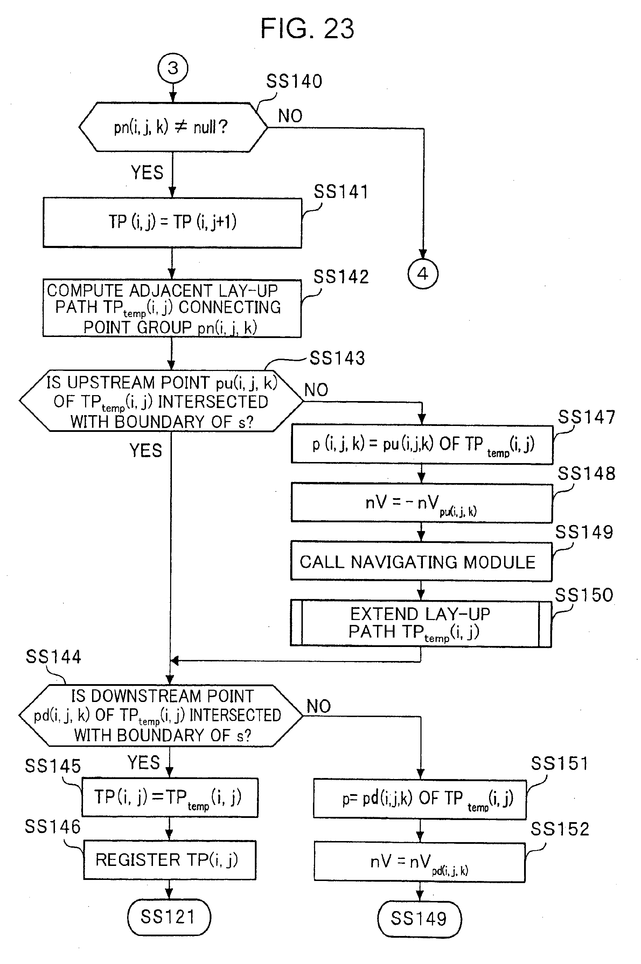

Next, referring to Fig. 23, when all of the terminal points Te are computed for one criterion line NL, it is then judged whether or not a basic point pn (i, j, k) exists, i.e., whether or not an adj acent lay-up path TPn to which the prepreg tape is adhered can be computed (step SS140).

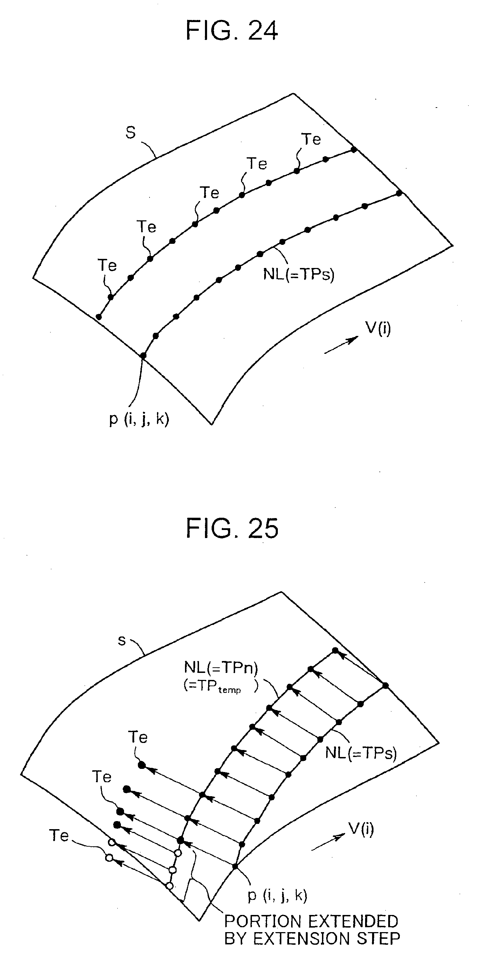

If the adjacent lay-up path TPn is determined to be computed for the one criterion line NL, the variable j of the lay-up path is updated (step SS141), and a temporary lay-up path $TP_{temp}$(i, j) obtained by connecting the basic points pn(i, j, k) is computed (step SS142). Herein, it is judged whether or not an upstream point pu(i, j, k) and a downstream point pd (i, j, k) of the computed temporary lay-up path $TP_{temp}$(i, j) are contacting with respective boundaries of the curved surface S (steps SS143 and SS144). If the upstream and downstream points are contacting with the respective boundaries, the temporary lay-up path $TP_{temp}$(i, j) is defined as the adjacent lay-up path TPn (step SS145), and the adjacent lay-up path TPn is registered (step SS146) . Thus, as shown in Fig. 24, an adjacent lay-up path TPn having the criterion lay-up path TPs as the criterion line NL is computed and registered. Then, the flow moves on to the step SS121, the computed adjacent lay-up path TPn is used as a criterion line NL of the next computing, and the above-described computing is repeated.

On the other hand, if the upstream point of the temporary lay-up path $TP_{temp}$(i, j) does not reach the boundary of the curved surface S in the step SS143, the upstream point pu(i, j, k) of the temporary lay-up path $TP_{temp}$(i, j) is defined as a start point p(i, j, k) (step SS147), and a direction at the upstream point pu(i, j, k) of $TP_{temp}$(i, j), opposite to a direction of the unit exploring vector nVpu(i, j, k) serving as a movement direction vector is defined as a unit exploring vector nV (step SS148). Subsequently, the navigating module 26 is called (step SS149), and the temporary lay-up path $TP_{temp}$(i, j) is extended (step SS150). Thus, as shown in Fig. 25, the temporary lay-up path $TP_{temp}$(i, j) the end of which does not reach is extended to the boundary of the curved surface S.

Also, if the downstream point pd (i, j, k) of the temporary lay-up path $TP_{temp}$(i, j) does not reach the boundary of the curved surface S in the step SS144, the downstream point pd (i, j, k) of the temporary lay-up path $TP_{temp}$(i, j) (step

SS151) is defined as the start point p (i, j, k), and the direction of the unit exploring vector $nV_{pd(i,j,k)}$ as the movement direction vector of $TP_{temp}(i, j)$ at the downstream point pd(i, j, k) is defined as the unit exploring vector nV (step SS152). Next, the flow moves on to the step SS149, so that the temporary lay-up path $TP_{temp}(i, j)$ the end of which does not reach on the downstream side is also extended to the boundary of the curved surface S.

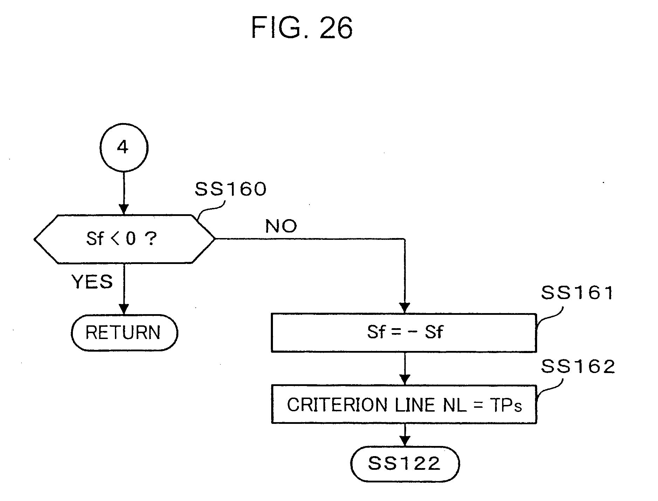

If the temporary lay-up path $TP_{temp}(i, j)$ (i.e., the adjacent lay-up path TPn) is unable to compute in the step SS140, the sign of the exploring value Sf is determined (step SS160), as shown in Fig. 26. When the exploring value Sf is negative, the flow returns to the main routine. Thus, all of the computing of the adjacent lay-up path TPn in the layer i is ended, the control returns to the main flow of Fig. 6, and the processing in the step S29 and subsequent steps is executed.

On the other hand, if the exploring value Sf is positive, the exploring value Sf is changed to a negative value (step SS161), and the criterion lay-up path TPs is set as a criterion line NL (step SS162) . Thereafter, the flow moves on to Step SS122, thereby enabling to perform the computing of the adjacent lay-up path TPn on the surface on the opposite side of the criterion lay-up path TPs.

As described above, the present embodiment includes the three-dimensional data reading step S20 of reading the three-dimensional data on the curved surface S as the adhesion surface of the prepreg tape, the criterion lay-up path setting steps SS101 to SS113 of setting the criterion lay-up path along the adhesion direction V (i) of the prepreg tape to be adhered on the stored curved surface S, and the adjacent lay-up path setting steps SS120 to SS162 of setting the adjacent lay-up path TPn adjacent to the criterion lay-up path TPs based on the criterion lay-up path TPs set in the criterion lay-up path setting steps SS101 to SS113, and each of the lay-up path setting steps include the exploring vector computing step S101 wherein the exploring vector SV based on the adhesion direction V (i) of the prepreg tape to be adhered on the curved surface S of the prepreg tape is computed by using the specific small movement amount $\Delta a$ as a scalar with the arbitrary initial coordinate p0 provided on the stored curved surface S used as the start point, the foot computing step S102 in which the foot $p_{temp0}(i, j, k)$ of the perpendicular from the terminal point pe of the computed exploring vector SV to the curved surface S is computed, and the navigating steps S100 to S125 in which the new exploring vector SV is computed based on the foot $p_{temp0}(i, j, k)$ of the perpendicular and the initial point of the exploring vector SV, and the exploring vector computing step S101 is repeated based on the new exploring vector SV with the foot $p_{temp0}(i, j, k)$ of the perpendicular used as the start point of the next computing until the specific termination conditions shown in Figs. 7 and 8 are satisfied. Consequently, according to the present embodiment, by executing the navigating steps S100 to S125, it is possible to compute the exploring vector SV which advances in the adhesion direction V (i) of the prepreg tape by a small amount with the initial coordinate p0 set on the adhesion surface having various curved surfaces used as the initial point, and repeat the computing recursively by using the foot $p_{temp0}(i, j, k)$ of the perpendicular from the terminal point of the exploring vector to the curved surface S as the computing criterion, and hence the point serving as the computing criterion becomes the criterion for accurately computing the path along the curved surface. As a result, by computing the path based on the initial points p(i, j, k) successively computed by the recursively repeated computing, it becomes possible to accurately compute the path which extends along the curved surface and prevents the formation of the wrinkle in the prepreg tape.

In addition, the present embodiment includes the initial coordinate setting steps SS101 to SS103 in which the foot $p_{temp0}(i, j, k)$ of the perpendicular to the curved surface S is computed from the initial coordinate p0 and the foot $p_{temp0}(i, j, k)$ of the perpendicular is set as the initial coordinate p0 at the beginning of the criterion lay-up path setting steps SS101 to SS113. Consequently, in the present embodiment, even when flexibility in the selection of the initial coordinate p0 is enhanced, it is possible to accurately perform the computing.

Further, in the present embodiment, the adjacent lay-up path setting steps SS120 to SS162 include the criterion point exploring step SS129 in which the criterion point Te serving as the computing criterion for the adjacent lay-up path TPn to be computed is searched for by executing the navigating steps S100 to S125 with a plurality of points p on the lay-up path serving as the computing base used as the start points and the exterior product of the unit exploring vector $nV_{NL}$ of the lay-up path and the unit normal vector $V_{NL}$ to the curved surface S when each start point is computed used as the unit exploring vector nV, and the criterion point connection step SS142 in which the adjacent lay-up path TPn is computed by connecting the points Te obtained by the search, and repeats the criterion point exploring step SS129 and the criterion point connection step SS142 with the computed adjacent lay-up path TPn used as the lay-up path serving as the base for the next computing until the specific termination conditions shown in Figs. 23 and 26 are satisfied. Consequently, in the present embodiment, when the adjacent lay-up path TPn spaced apart from a given lay-up path by a specific interval is computed, it is possible to accurately compute the interval from the lay-up path as the base to the next adjacent lay-up path TPn along the curved surface S and, since the adjacent lay-up path TPn is set based on the accurately computed interval, overlapping of the prepreg tape adhered to a given lay-up path and the prepreg tape adhered to the next adjacent lay-up path TPn can be prevented as much as possible, and the formation of a gap of an allowable value or more can also be prevented as much as possible.

In the present embodiment, in the adjacent lay-up path setting steps SS120 to SS162, in the case where the curved surface S is divided into two surfaces by the criterion lay-up path, after the adjacent lay-up path TPn is computed for one of the surfaces, the adj acent lay-up path TPn is computed for the other surface by executing the navigating steps S100 to S125 from the criterion lay-up path with the vector in the direction opposite to that of the exterior product used as the exploring vector SV. Consequently, in the present embodiment, since the adjacent lay-up path TPn is computed for each of the surfaces divided by the criterion lay-up path with the point on the criterion lay-up path used as the base, the computing error of each adjacent lay-up path TPn can be reduced to 1/2.

Further, in the present embodiment, in the criterion point connection step, the temporary lay-up path $TP_{temp}(i, j)$ is computed by connecting the criterion points, and the present embodiment further includes the lay-up extension steps SS143 to SS152 in which, in the case where the end portion of the computed temporary lay-up path $TP_{temp}(i, j)$ does not reach the boundary of the adhesion surface, the points pu $(i, j, k)$ and pd $(i, j, k)$ of the end portions of the temporary lay-up path $TP_{temp}(i, j)$ are used as the start points, a unit direction vector in an extension direction of $TP_{tem}(i, j)$ at each of the points pu $(i, j, k)$ and pd$(i, j, k)$ of the end portions is determined as the unit exploring vector nV, the end portion of the temporary lay-up path $TP_{temp}(i, j)$ is extended to the boundary of the curved surface S by executing the navigating steps S100 to S125, and the adjacent lay-up path TPn is thereby completed. Consequently, in the present embodiment, in the case where the length of the temporary lay-up path $TP_{temp}(i, j)$ computed by the criterion point connection step does not reach a specific length on the curved surface S, since it is possible to determine an accurate extension line from the end portion of the temporary lay-up path $TP_{temp}(i, j)$, it is possible to accurately compute the adjacent lay-up path TPn longer than the lay-up path having served as the base for the adjacent lay-up path TPn along the curved surface S.

In the present embodiment, in the exploring vector computing step S101, when the terminal point pe of the exploring vector SV exceeds the ridge line RL in the case where the curved surface S is intersected by the ridge line RL, the foot $p_{temp2}(i, j, k)$ of the perpendicular to the surface Sn adjacent to the surface Sb having been subjected to the search is computed. In a case where the foot $p_{temp2}(i, j, k)$ of the perpendicular to the adjacent surface Sn exists, the foot $p_{temp2}(i, j, k)$ of the perpendicular is used as the base for the next computing and, in a case where the foot $p_{temp3}(i, j, k)$ of the perpendicular to the adjacent surface Sn does not exist, the foot $p_{temp3}(i, j, k)$ of the perpendicular to the ridge line RL is computed, and is used as the base for the next computing. Consequently, in the present embodiment, as shown in Figs. 10 and 11, in the case where the prepreg tape adhesion path is computed on the curved surface S intersected by the ridge line RL, it becomes possible to compute the smooth adhesion path across the ridge line RL.

Further, in the present embodiment, in the criterion lay-up path setting steps SS101 to SS113, in a case where the prepreg tape is laminated on the curved surface S, the offset amount h(i) corresponding to the thickness of the prepreg tape along the normal to the curved surface S which passes through the foot $P_{temp0}(i, j, k)$ of the perpendicular determined from the initial coordinate p0 is determined, and the criterion lay-up path TPs is computed with the terminal point thereof used as the start point p(i, j, k) of the next layer. Consequently, in the present embodiment, since the start points p(i, j, k) in a plurality of the layers are set based on the initial coordinate p0 defined based on the curved surface S, the precise offset amount h (i) corresponding to the thickness of the tape to be laminated is determined, and the criterion lay-up path and the adjacent lay-up path TPn can be computed.

In the present embodiment, in the exploring vector computing step S101, the foot $p_{temp0}(i, j, k)$ of the perpendicular to the curved surface S is computed from the point serving as the computing criterion, and the point offset by the thickness t of the tape along the direction of the normal to the curved surface S which passes through the foot $p_{temp0}(i, j, k)$ of the perpendicular is set as the start point p(i, j, k) of the next computing. Consequently, in the present embodiment, it is possible to offset by the thickness t of the prepreg tape relative to the curved surface S to totalize the path, and hence it is possible to compute the precise path even in a case where the adhesion path of the tape adhered to a plurality of the layers is computed. As described above, the "point serving as the computing criterion" means the initial coordinate p0 at the first stage of the computing, and means the initial point p(i, j, k) of the next exploring vector SV after the exploring vector is computed from the initial coordinate p0.

Further, in the present embodiment, in a case where the adhesion directions V (i) of the prepreg tape set in a plurality of the layers are overlapped, the coordinate of the initial coordinate p0 in the upper layer is shifted in the width direction of the tape.

In the present embodiment, in the criterion lay-up path setting steps SS101 to SS113, after the first half lay-up path TP(i, f) along the specific exploring vector SV set from the initial coordinate p0 is computed, the second half lay-up path TP (i, 1) along the exploring vector in the direction opposite to the direction of the specific exploring vector SV set from the initial coordinate p0 is computed, and the first half lay-up path TP(i, f) and the second half lay-up path TP(i, 1) are connected to each other. In this aspect, with the initial coordinate used as the criterion, the criterion lay-up path TP(i, j) is divided into the first half lay-up path TP(i, f) and the second half lay-up path TP (i, I), and they are computed separately, and hence the computing error of each of the lay-up paths TP(i, f) and TP(i, 1) can be reduced to 1/2.

The above-described embodiment simply exemplifies a preferred specific example of the present invention, and the present invention is not limited to the above-described embodiment. For example, in a case where the product has a spherically curved surface, if the set value Lh is set when the criterion lay-up path TPs is computed and the computing of a circling path is made possible, it is possible to compute the criterion lay-up path TPs along the curved surface and the adjacent lay-up path TPn.

It will be understood that various changes can be made within the scope of claims of the present invention.

**Claims**

1. A route computing method of a prepreg tape for automatically computing a prepreg tape adhesion path, comprising:

a three-dimensional data reading step of reading three-dimensional data on an adhesion surface of the tape;
a criterion lay-up path setting step of setting a criterion lay-up path along an adhesion direction of the prepreg tape to be adhered in stored three-dimensional data; and
an adjacent lay-up path setting step of setting an adjacent lay-up path that is adjacent to the criterion lay-up path, the adjacent lay-up path is set based on the criterion lay-up path set in the criterion lay-up path setting step, wherein each of the lay-up path setting steps includes:

an exploring vector computing step of defining an arbitrary initial coordinate provided in stored three-dimensional data used as a start point, and computing an exploring vector having a small amount from the start point based on the adhesion direction of the prepreg tape to be adhered on the adhesion surface of the prepreg tape; and
a foot computing step of computing a foot of perpendicular from a terminal point of the computed exploring vector to the adhesion surface,

the method further comprises a navigating step of computing a new exploring vector based on the foot of perpendicular and an initial point of the exploring vector, and repeating the exploring vector computing step based on the new exploring vector with the foot of perpendicular, until a specific termination condition is satisfied.

2. The route computing method of a prepreg tape according to claim 1, wherein the adjacent lay-up path setting step includes: a criterion point exploring step of exploring a criterion point serving as a computing criterion for an adjacent lay-up path to be computed, by executing the navigating step based on execution of defining a lay-up path serving as a computing base used as a criterion line, defining a plurality of points on the criterion line as a start point, and computing an exterior product of the exploring vector and the unit normal vector for defining a new exploring vector; and a criterion points connecting step of connecting the criterion points for computing the adjacent lay-up path, wherein the adjacent lay-up path setting step repeatedly executes the criterion point exploring step and the criterion points connecting step using the computed adjacent lay-up path as a criterion lay-up path for a next computing, until a specific termination condition is satisfied.

3. The route computing method of a prepreg tape according to claim 2, wherein, in a case where the adhesion surface is divided into one surface and other surface by the criterion lay-up path, the adjacent lay-up path setting step is configured to be executed by way of computing an adjacent lay-up path with respect to the one surface, and subsequently computing an adjacent lay-up path with respect to the other surface executing the navigating step from the criterion lay-up path upon defining a new exploring vector by reversing a vector obtained from the exterior product.

4. The route computing method of a prepreg tape according to claim 2 or 3, wherein the criterion point connecting step is configured to complete a temporary lay-up path by connecting each of the criterion points, and wherein further comprises a lay-up extension step of completing an adjacent lay-up path by extending an end portion of the temporary lay-up path to a boundary of the adhesion surface, in a case where an end portion of the computed temporary lay-up path does not reach a boundary of the adhesion surface, wherein the lay-up extension step executes the navigating step by way of defining a terminal point of the temporary lay-up path as a start point, and computing an exploring vector based on a movement direction vector with respect to the terminal point of the temporary lay-up path.

5. The route computing method of a prepreg tape according to any one of claims 1 to 4, wherein, in a case where the adhesion surface is intersected by the ridge line and a terminal point of the exploring vector exceeds the ridge line, the exploring vector computing is executed by way of computing a foot of perpendicular with respect to an adjacent surface, which is adjacent to an explored surface such that the adjacent surface and the explored surface are intersected with a ridge line, the exploring vector is computed by defining the foot of perpendicular as a criterion for next computing if the foot of perpendicular with respect to the adjacent surface exists, a foot of perpendicular on the ridge as a criterion for next computing is computed, on the other hand, if the foot of perpendicular on the adjacent surface does not exist.

6. The route computing method of a prepreg tape according to any one of claims 1 to 5,
wherein, in a case where a tape is to be laminated on the adhesion surface, the criterion lay-up path setting is executed by way of computing an offset amount, which corresponds to a thickness of the prepreg tape, along a normal to an adhesion surface passing through a foot of perpendicular determined from the initial coordinate, and computing a criterion lay-up path with a terminal point used as a start point of a next layer, and
the exploring vector computing is executed by way of computing a foot of perpendicular with respect to the adhesion surface from a point serving as a computing criterion, and setting a point, which is offsetting by the thickness of the tape along a direction of the normal, to the adhesion surface which passes through the foot of perpendicular as a start point of next computing.

## FIG. 1A

WS

S

TP

## FIG. 1B

WS

S

TP

# FIG. 2A

# FIG. 2B

# FIG. 3

# FIG. 4

CAD SYSTEM 10

CAD DATABASE 11

30

PATH COMPUTING MODULE 20

INPUT/OUTPUT DEVICE 21

CAD DATA PROCESSING MODULE 24

DISPLAY DEVICE 22

LAY-UP PLAN PROCESSING MODULE 25

EXTERNAL STORAGE DEVICE 23

NAVIGATING MODULE 26

# FIG. 5

LAYER 1

LAYER 2

LAYER 3

# FIG. 6

```
        START
          │
          ▼
┌──────────────────────┐  S20
│   READ CAD DATA      │
└──────────────────────┘
          │
          ▼
┌──────────────────────┐  S21
│    INPUT TAPE        │
│   LAY-UP PLAN        │
└──────────────────────┘
          │
          ▼
┌──────────────────────┐  S22
│    n = count(i)      │
└──────────────────────┘
          │
          ▼
┌──────────────────────┐  S23
│       i = 1          │
└──────────────────────┘
          │
          ▼
┌──────────────────────┐  S24
│    j = 1, k = 1      │
└──────────────────────┘
          │
          ▼
┌──────────────────────┐  S25
│  READ TAPE LAY-UP    │
│   PLAN OF LAYER i    │
└──────────────────────┘
          │
          ▼
    ╱─────────────────╲  S26
   ╱ DOES ADHESION     ╲      NO
  ╱  SURFACE EXIST IN   ╲──────────┐
  ╲  IDENTICAL           ╱         │
   ╲ DIRECTION?        ╱           │
    ╲─────────────────╱            │
          │ YES                    │
          ▼                        │
┌──────────────────────┐  S27      │
│  COMPUTING SHIFT     │           │
│     AMOUNT           │           │
└──────────────────────┘           │
          │                        │
          ▼                        │
┌──────────────────────┐  S28      │
│     SHIFT p0         │           │
└──────────────────────┘           │
          │◄──────────────────────┘
          ▼
┌──────────────────────┐  SS10
│     COMPUTING        │
│    PROCESSING        │
└──────────────────────┘
          │
          ▼
┌──────────────────────┐  S29
│     i = i + 1        │
└──────────────────────┘
          │
          ▼
    ╱─────────────╲  S30
NO ╱   i > n ?     ╲
◄──╲              ╱
    ╲───────────╱
          │ YES
          ▼
        END
```

i: LAYER
j: LINE
k: POINT
d: TAPE WIDTH
   (+ ALLOWANCE VALUE/2)
t: TAPE THICKNESS
v(i): ADHESION DIRECTION
p0: INITIAL COORDINATE

## FIG. 7

NAVIGATING MODULE

h(i): OFFSET AMOUNT ((i-1)*t)
$\Delta$a: SMALL MOVEMENT AMOUNT
m: TOTAL MOVEMENT AMOUNT
nV: UNIT EXPLORING VECTOR (vi/|vi|)

S100
$\Delta$a=0.001; m=0; k=0;
P0=P(i, j, k)

S101
COMPUTE Pe FROM
SV=$\Delta$a * nV: P0

S102
COMPUTE FOOT $p_{temp1}$ OF
PERPENDICULAR FROM Pe TO S

S103
CAN $p_{temp1}$
BE COMPUTE IN S? — NO

YES

S104
Ps=$p_{temp1}$+hv * h(i)

S105
$\Delta$m= | Ps−P0 |

S106
NO — Lh $\neq$ null ?

YES

S107
(m+$\Delta$m) $\leqq$ Lh? — NO

YES

①

S108
K=K+1

S109
p (i, j, k) = Ps

S110
REGISTER p(i, j, k)

S111
$$nV = \frac{(p - p(i, j, k - 1))}{|p - p(i, j, k - 1)|}$$

S112
m=m+$\Delta$m

S101

S113
m < Lh? — NO

YES

S114
$$p = p(i, j, k) + \frac{Lh - m}{\Delta m}(p - p(i, j, k))$$

S115
k=k+1

S116
p(i,j,k) = p

S117
REGISTER p(i, j, k)

S118
COMPUTE TP(i, j)
BASED ON p(i, j, k) GROUP

RETURN

# FIG. 8

① S120
DOES SURFACE Sn EXIST?
— NO

YES

S121
COMPUTE FOOT $p_{temp2}$ OF PERPENDICULAR FROM pe TO SURFACE Sn

S126
DOES p(i, j, k) EXIST IN SURFACE?
— NO

YES

S122
IS $p_{temp2}$ COMPUTABLE IN S?
— NO

YES

S113

S124
COMPUTE FOOT $p_{temp3}$ OF PERPENDICULAR FROM pe TO RL

S123
$p = p_{temp2} + hv * h(i)$

S125
$p = p_{temp3} + hv * h(i)$

S105

# FIG. 9A

# FIG. 9B

## FIG. 10

## FIG. 11

FIG. 12

$$SS10$$ COMPUTING PROCESSING

$$SS101$$ DETERMINE FOOT $p_{temp0}$ OF PERPENDICULAR TO S FROM p0

$$SS102$$ $p0 = p_{temp0} + hv * h(i)$

$$SS103$$ REGISTER p0

$$SS104$$ Lh = null

$$SS105$$ $nV = V(i) / |V(i)|$

$$SS106$$ $p(i, j, k) = p0$

$$SS107$$ CALL NAVIGATING MODULE

$$SS108$$ COMPUTE FIRST HALF TP(i, f) OF REFERENCE LAY-UP PATH

$$SS109$$ $nV = -nV, \ p(i, j, k) = p0$

$$SS110$$ CALL NAVIGATING MODULE

$$SS111$$ COMPUTE SECOND HALF TP(i, l) OF REFERENCE LAY-UP PATH

$$SS112$$ CRITERION LAY-UP PATH $TPs = TP(i, f) + TP(i, l)$

$$SS113$$ REGISTER TPs

( 2 )

## FIG. 13A

S

p(i, j, k)
(=p0)

## FIG. 13B

p0

S

p(i, j, k)
(=$p_{temp0}$)

## FIG. 13C

p0

p(i, j, k)

S(i)

S(1)

h(i)

hV

$p_{temp0}$

## FIG. 14

## FIG. 15

## FIG. 16

## FIG. 17

# FIG. 18

## FIG. 19

```
        ( 2 )
          │
          ▼
```

$Sf = d, \ Lh = |Sf|, \ TP(i,j) = TPs$ — SS120

CRITERION LINE $NL = TP(i,j)$ — SS121

UPSTREAM POINT $p(i, j, k)$ OF NL — SS122

$L = length(NL)$ — SS123

$Ln = 0.0, \ \Delta Ln = 0.1$ — SS124

$nV = hV_{NL} \times nV_{NL}$ — SS125

SS126 — $Sf < 0$ — NO / YES

$nV = -nV$ — SS127

CALL NAVIGATING MODULE — SS128

COMPUTE NATURAL PATH $TP(i,j)$ IN nV DIRECTION FROM $p(i, j, k)$ OF NL — SS129

SS130 — LENGTH OF $TP(i,j) \geqq Lh$? — NO / YES

REGISTER END POINT Te OF $TP(i,j)$ AS BASIC POINT $pn(i, j, k)$ ON ADJACENT LAY-UP PATH — SS131

$Ln = Ln + \Delta Ln$ — SS132

SS133 — $Ln > L$? — NO / YES

ADVANCE $p(i, j, k)$ ON NL BY $\Delta Ln$ ($p(i, j, k) = Ln$-CORRESPONDING POINT ON NL) — SS134

( 3 )

SS125

## FIG. 20

## FIG. 21

# FIG. 22

# FIG. 23

③

SS140

$pn(i, j, k) \neq null?$ — NO

YES

SS141

$TP(i, j) = TP(i, j+1)$

SS142

COMPUTE ADJACENT LAY-UP PATH $TP_{temp}(i, j)$ CONNECTING POINT GROUP $pn(i, j, k)$

④

SS143

IS UPSTREAM POINT $pu(i, j, k)$ OF $TP_{temp}(i, j)$ INTERSECTED WITH BOUNDARY OF $s$? — NO

YES

SS147

$p(i, j, k) = pu(i,j,k)$ OF $TP_{temp}(i, j)$

SS148

$nV = -nV_{pu(i, j, k)}$

SS149

CALL NAVIGATING MODULE

SS150

EXTEND LAY-UP PATH $TP_{temp}(i, j)$

SS144

IS DOWNSTREAM POINT $pd(i, j, k)$ OF $TP_{temp}(i, j)$ INTERSECTED WITH BOUNDARY OF $s$? — NO

SS145

YES

$TP(i, j) = TP_{temp}(i, j)$

SS151

$p = pd(i,j,k)$ OF $TP_{temp}(i, j)$

SS146

REGISTER $TP(i, j)$

SS152

$nV = nV_{pd(i, j, k)}$

SS121

SS149

# FIG. 24

S

Te
Te
Te
Te
Te
Te

NL(=TPs)

V(i)

p (i, j, k)

# FIG. 25

s

NL(=TPn)
(=TP$_{temp}$)

Te
Te
Te

NL(=TPs)

V(i)

p (i, j, k)

PORTION EXTENDED
BY EXTENSION STEP

## FIG. 26

SS160

Sf < 0 ?

NO

YES

RETURN

Sf = − Sf    SS161

CRITERION LINE NL = TPs    SS162

SS122

| | | |
|---|---|---|
| **INTERNATIONAL SEARCH REPORT** | International application No. | |
| | PCT/JP2011/003258 | |

**A. CLASSIFICATION OF SUBJECT MATTER**
*B29C70/06*(2006.01)i

According to International Patent Classification (IPC) or to both national classification and IPC

**B. FIELDS SEARCHED**

Minimum documentation searched (classification system followed by classification symbols)
B29C70/06

Documentation searched other than minimum documentation to the extent that such documents are included in the fields searched
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| P,X | JP 2011-121281 A (Shin Nippon Koki Co., Ltd.), 23 June 2011 (23.06.2011), claims 1 to 6 (Family: none) | 1-6 |
| A | JP 1-295833 A (Shin Nippon Koki Co., Ltd.), 29 November 1989 (29.11.1989), page 4, lower right column, line 12 to page 5, upper left column, line 18; page 5, lower left column, line 14 to lower right column, line 4; fig. 8 to 15 & US 5041179 A | 1-6 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 August, 2011 (25.08.11) | 06 September, 2011 (06.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| | International application No. |
|---|---|
| | PCT/JP2011/003258 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-152614 A (Mitsubishi Heavy Industries, Ltd.), 21 June 2007 (21.06.2007), entire text (Family: none) | 1-6 |
| A | JP 2008-515665 A (The Boeing Co.), 15 May 2008 (15.05.2008), entire text & US 2006/0073309 A1 & US 2006/0073311 A1 & US 2011/0014429 A & EP 1814719 A & WO 2006/041768 A1 | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007185947 A